# DEMANDE DE BREVET EUROPEEN

(11) **EP 0 795 778 A1**
(43) Date de publication de la demande: **17.09.1997**
(21) Numéro de dépôt: 97400561.3
(22) Date de dépôt: 13.03.1997
(51) Int. Cl.: G02F 1/35, G02F 2/02, H01S 3/025

(54) **Dispositif optique non-linéaire de traitement de signaux optiques**

(30) Priorité: 15.03.1996 FR 9603299
(71) Demandeur: FRANCE TELECOM, 75015 Paris (FR)
(72) Inventeur: Devaux, Fabrice, 92120 Montrouge (FR); Sigogne, Didier, 91140 Villebon Sur Yvette (FR); Chelles, Sandrine, 92160 Antony (FR)
(74) Mandataire: Dubois-Chabert, Guy

(57) **Abrégé**

Ce dispositif comprend un interféromètre optique comportant deux bras (8, 10) destinés à recevoir un signal optique à traiter, et deux amplificateurs optiques à semiconducteurs (12, 14) insérés dans les deux bras, de manière à pouvoir modifier l'indice de réfraction de l'un de ces amplificateurs par injection d'un signal de pompe dans le bras correspondant. Les caractéristiques optogéométriques ou structurelles d'au moins l'un des deux bras de l'interféromètre sont adaptées à l'introduction d'un déphasage égal à π entre les deux bras. Application aux télécommunications par fibres optiques.

## Description

### DOMAINE TECHNIQUE

La présente invention concerne un dispositif optique non-linéaire de traitement de signaux optiques.

Elle s'applique tout particulièrement aux télécommunications par fibres optiques.

Le dispositif objet de l'invention est un dispositif optique non-linéaire rapide, qui permet divers traitement de signaux optiques.

La non-linéarité du dispositif résulte du fait que la puissance optique à la sortie de ce dispositif n'est pas proportionnelle à la puissance optique à l'entrée de celui-ci, et cela même en régime transitoire.

Grâce à cette non-linéarité, un signal optique peut être modulé par les variations de puissance optique d'un autre signal optique.

Si les longueurs d'onde de ces deux signaux sont différentes, les informations que l'on veut transmettre sont transférées d'un canal à un autre canal.

Un tel traitement, appelé traitement de conversion de longueurs d'onde, est intéressant pour la transmission d'informations dans un système fondé sur le multiplexage en longueur d'onde.

On distingue en général quatre types de non-linéarités : le type sur-linéaire inversé, le type sur-linéaire non inversé, le type sous-linéaire inversé et le type sous-linéaire non-inversé.

Suivant le type de non-linéarité, le dispositif objet de l'invention peut être utilisé pour la remise en forme ou le démultiplexage de signaux optiques ou pour l'extraction d'un signal d'horloge à partir d'un train d'impulsions optiques dans un système fondé sur le multiplexage temporel.

### ÉTAT DE LA TECHNIQUE ANTÉRIEURE

Il est relativement difficile de concevoir un composant optique qui soit à la fois non-linéaire et rapide pour des puissances optiques "raisonnables", du genre de celles que l'on utilise pour les télécommunications optiques.

Une solution connue consiste à utiliser la saturation des amplificateurs optiques à semiconducteurs.

On consultera à ce sujet le document (1) qui, comme les autres documents cités par la suite, est mentionné à la fin de la présente description.

Une telle solution conduit à deux types de dispositifs, l'un qui est fondé sur la saturation du gain des amplificateurs optiques à semiconducteurs et l'autre qui est fondé sur la saturation de l'indice de réfraction de ces amplificateurs.

Les dispositifs du premier type utilisent de simples amplificateurs optiques à semiconducteurs tels qu'ils ont été développés pour l'amplification de signaux optiques.

Dans ce cas, la non-linéarité obtenue, qui est du type sous-linéaire inversé, est contraire à celle qui est recherchée pour la plupart des applications et qui est du type sur- ou sous-linéaire non-inversé.

Les dispositifs du deuxième type utilisent l'introduction d'un amplificateur optique à semiconducteur dans un interféromètre optique réalisé sur un substrat semiconducteur.

Cet interféromètre peut être :
- un interféromètre de Michelson (voir le document (2))
- ou un interféromètre de Mach-Zehnder asymétrique (voir le document (3))
- ou un interféromètre de Mach-Zehnder symétrique (voir le document (4)).

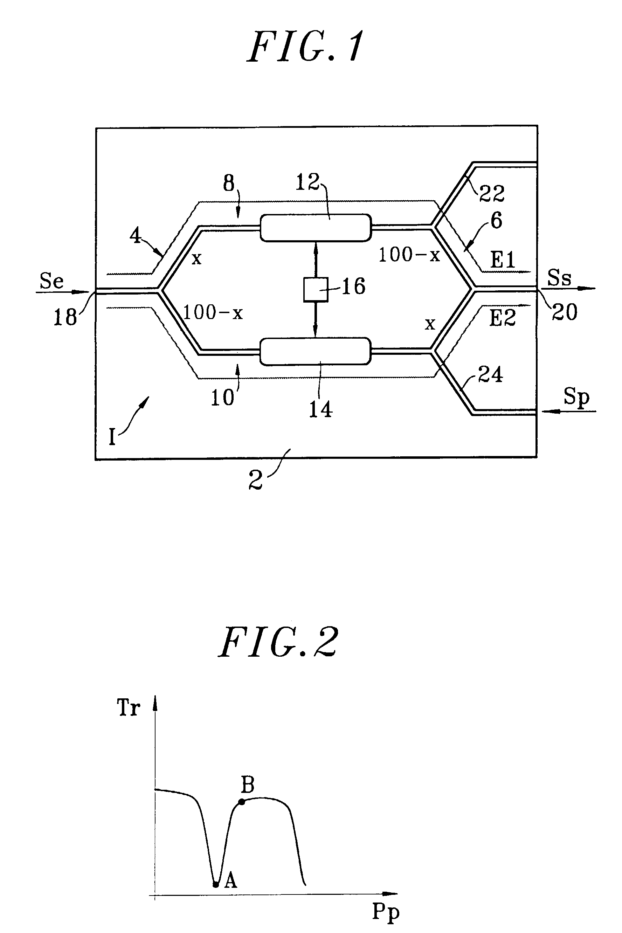

La figure 1 est une vue schématique d'un dispositif optique non-linéaire connu pour le traitement d'un signal optique.

Ce dispositif de la figure 1 comprend un interféromètre de Mach-Zehnder I formé sur un substrat semiconducteur 2.

Cet interféromètre comprend deux jonctions optiques en Y qui sont formées sur le substrat 2 et ont respectivement les références 4 et 6 sur la figure 1.

L'interféromètre comprend aussi deux guides d'ondes optiques 8 et 10 parallèles et de même longueur, qui constituent les bras de l'interféromètre et raccordent les jonctions 4 et 6 l'une à l'autre, comme on le voit sur la figure 1.

Le dispositif représenté sur celle-ci comprend en outre deux amplificateurs optiques à semiconducteurs 12 et 14 identiques, qui sont formés sur le substrat 2 et respectivement insérés dans les bras 8 et 10 de l'interféromètre, comme on le voit sur la figure 1.

Ce dispositif est muni de moyens 16 destinés à alimenter les amplificateurs 12 et 14 par des courants de polarisation *("biasing currents").*

La notion de symétrie ou d'asymétrie d'un interféromètre de type Mach-Zehnder est relative à la puissance optique.

Plus précisément, en considérant l'interféromètre I de la figure 1, cette symétrie ou cette asymétrie concerne les deux jonctions optiques 4 et 6.

L'interféromètre de Mach-Zehnder est dit symétrique lorsque ces deux jonctions sont des jonctions 50:50 (c'est-à-dire lorsque la répartition de puissance optique correspondante est 50%:50%).

L'interféromètre de Mach-Zehnder est dit asymétrique lorsque la jonction optique 4 est de type x:(100-x) et que la jonction optique 6 est de type (100-x):x avec x≠50, la répartition de puissance optique correspondante étant alors x%:(100%-x%) pour la jonction 4 et (100%-x%):x% pour la jonction 6.

Dans les deux cas (interféromètre de Mach-Zehnder de type symétrique et interféromètre de Mach-Zehnder de type asymétrique), étant donné un signal optique continu Se (c'est-à-dire un signal dont la puissance optique est constante au cours du temps) qui est injecté à l'entrée 18 du dispositif de la figure 1 (entrée de la jonction 4 du dispositif), les champs optiques E1 et E2 correspondant à ce signal Se ont la même amplitude à la sortie 20 du dispositif (sortie de la jonction optique 6).

On précise que, dans le cas d'un interféromètre de Mach-Zehnder asymétrique, le signal de pompe *("pump signal"),* qui est destiné à interagir avec le signal Se injecté à l'entrée 18 du dispositif et dont il sera question par la suite, peut, quant à lui, être injecté par l'entrée ou par la sortie du dispositif, ce qui permet de limiter le nombre d'accès optiques du dispositif.

Considérons, à titre d'exemple, un dispositif utilisant un interféromètre de Mach-Zehnder symétrique.

Dans ce cas, le paramètre x est égal à 50.

Comme on le voit sur la figure 1, l'interféromètre est muni de deux jonctions optiques 22 et 24 qui sont formées sur le substrat 2 et respectivement couplées aux bras 8 et 10 de l'interféromètre, du côté de la jonction optique 6.

L'une des jonctions 22 et 24, à savoir la jonction 24 dans le cas de la figure 1, permet l'injection d'un signal de pompe Sp dans le bras 10 de l'interféromètre.

La jonction 22, qui est associée à l'autre bras 8, ne sert qu'à équilibrer l'interféromètre de Mach-Zehnder, en ce qui concerne la puissance optique, pour que les amplitudes des champs optiques E1 et E2 soient identiques quand ces champs optiques interfèrent en sortie.

En injectant un signal de pompe Sp de puissance optique suffisante dans le bras 10 de l'interféromètre, l'indice de réfraction de l'amplificateur optique à semiconducteur 14 correspondant est modifié par saturation.

Il en résulte une variation de phase du champ optique E2 par rapport au champ optique E1.

Cette variation de phase est transformée, par interférence, en variation de transmission de l'interféromètre de Mach-Zehnder.

Dans ces conditions, en injectant un signal optique continu Se à l'entrée 18 du dispositif de la figure 1, ce signal Se est modulé par le signal de pompe Sp et l'on obtient à la sortie 20 du dispositif un signal optique de sortie Ss qui est modulé.

En l'absence de signal de pompe, si les deux amplificateurs 12 et 14 sont polarisés par le même courant électrique, le déphasage induit des deux bras 8 et 10 de l'interféromètre I est identique.

La transmission optique de cet interféromètre I est donc maximale lorsque celui-ci est au repos c'est-à-dire lorsqu'il n'y a pas de signal de pompe.

L'injection d'un signal de pompe modifie le déphasage d'un bras.

La courbe de transmission de l'interféromètre I est typiquement celle qui est représentée sur la figure 2 où Tr représente la transmission et Pp représente la puissance du signal de pompe.

Le déphasage correspond à des interférences constructives pour une puissance de pompe nulle, destructives (déphasage égal à π) au point A de la courbe et à nouveau constructives (déphasage égal à 2π) au point B de la courbe.

La non-linéarité idéale est obtenue entre les points A et B de la courbe car elle permet de ne pas inverser le signal Se lors de la conversion de celui-ci (c'est-à-dire lorsque la modulation du signal de pompe Sp est "transférée" à ce signal d'entrée Se) et permet également d'améliorer la qualité du signal de sortie Ss.

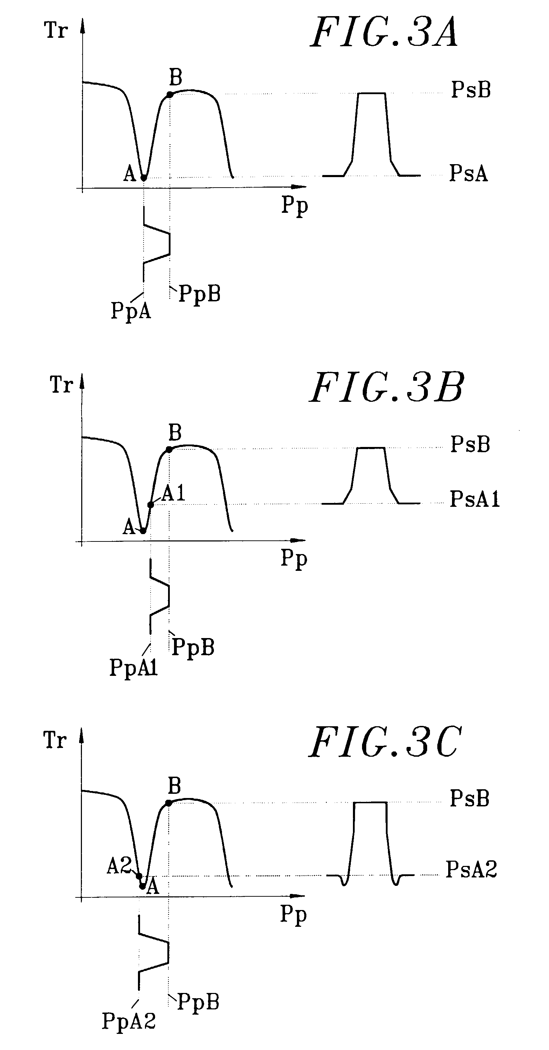

Ce fonctionnement est schématiquement illustré sur les figures 3A, 3B et 3C.

Sur ces figures, la puissance optique PpB relative au niveau haut du signal de pompe correspond au point B de la courbe de transmission de la figure 2.

Sur la figure 3A, la puissance optique PpA relative au niveau bas du signal de pompe correspond au point A de cette courbe de transmission (cas idéal).

Dans ce cas de la figure 3B (respectivement 3C), la puissance optique relative au niveau bas du signal de pompe est notée PpA1 (respectivement PpA2) et correspond à un point A1 (respectivement A2) qui est différent du point A.

Sur les figures 3A à 3C, la puissance optique relative au niveau haut du signal de sortie modulé est notée PsB et la puissance optique relative au niveau bas de ce signal de sortie est respectivement notée PsA, PsA1 et PsA2 sur les figures 3A, 3B et 3C.

On définit le taux d'extinction de sortie comme le nombre égal à la puissance optique relative au niveau bas du signal de sortie divisée par la puissance optique relative au niveau haut de ce signal.

On définit également le taux d'extinction d'entrée comme le nombre égal à la puissance optique relative au niveau bas du signal de pompe divisée par la puissance optique relative au niveau haut de ce signal.

Dans le cas idéal de la figure 3A, le taux d'extinction de sortie est bien meilleur que le taux d'extinction d'entrée.

Comme le montre la figure 3B, c'est encore le cas lorsque le taux d'extinction d'entrée est moins bon que celui qui correspond à la figure 3A, c'est-à-dire lorsque le niveau bas du signal de pompe correspond à une puissance optique supérieure à PpA.

Comme le montre la figure 3C, lorsque le taux d'extinction d'entrée est meilleur que celui correspondant à la figure 3A c'est-à-dire lorsque la puissance optique correspondant au niveau bas du signal de pompe est inférieure à PpA, le signal de sortie est dégradé.

La valeur idéale du taux d'extinction d'entrée est relativement mauvaise -elle est égale à -7 dB dans le document (4)- car PpA ne peut pas être très différent de PpB/2 (valeur pour un déphasage qui varie de façon linéaire avec la puissance).

Elle ne correspond donc pas à des signaux modulés réalistes (taux d'extinction inférieur à -10 dB).

Ceci constitue un premier inconvénient de la configuration considérée où les deux amplificateurs sont polarisés ("biased") avec le même courant.

Le deuxième inconvénient de cette configuration est que le taux d'extinction de sortie est limité par le déséquilibrage en puissance de l'interféromètre de Mach-Zehnder.

En effet, au points A, la signal de pompe sature d'amplificateur optique à semiconducteur qui le reçoit, ce qui induit un déphasage égal à π sur l'onde optique qui se propage dans le bras correspondant à cet amplificateur.

Or, la modification de l'indice de réfraction de cet amplificateur implique une variation du gain de l'amplificateur saturé (cette variation étant typiquement de l'ordre de 3 à 6 dB).

Les signaux optiques se propageant respectivement dans les deux bras n'ayant pas la même amplitude, ils ne peuvent interférer qu'avec un contraste dégradé.

Le taux d'extinction de sortie est donc limité par le déséquilibrage de l'interféromètre de Mach-Zehnder, ce déséquilibrage résultant de la saturation de l'amplificateur optique à semiconducteur dans lequel est envoyé le signal de pompe.

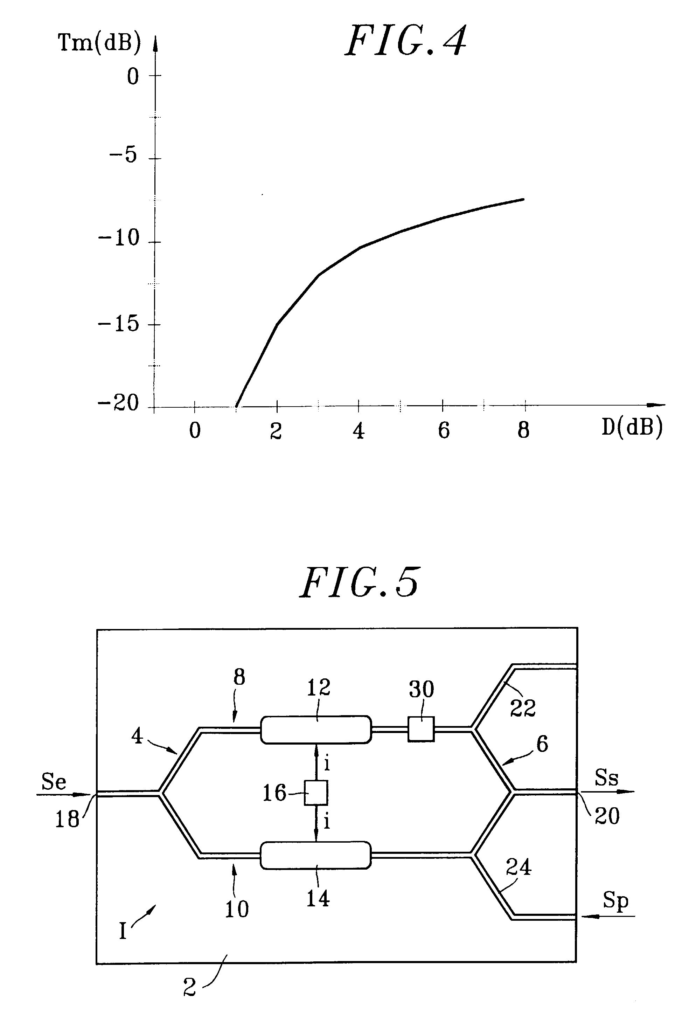

Ceci est illustré par la figure 4 où le déséquilibrage D est porté en abscisse et exprimé en dB.

Ce déséquilibrage est égal au rapport des puissances optiques dans les deux bras avant interférence.

Sur la figure 4, le taux d'extinction maximal de sortie Tm, est porté en ordonnée et exprimé en dB.

Or, un taux d'extinction réaliste pour une utilisation pratique du dispositif est égal à -15 dB.

Cela correspond à un déséquilibrage de 2 dB, valeur difficilement réalisable avec les amplificateurs optiques à semiconducteurs.

En résumé, dans le cas de la configuration où les deux courants de polarisation correspondant respectivement aux deux amplificateurs optiques à semiconducteurs sont identiques, le fonctionnement du dispositif connu présente deux inconvénients :
- le taux d'extinction de sortie n'est bon que si le taux d'extinction d'entrée est moins bon qu'une valeur idéale (par exemple égale à -7 dB dans le document (4)) et
- ce taux d'extinction de sortie est limité à cause du déséquilibrage provenant du couplage phase-gain de l'amplificateur saturé.

Il est également connu de polariser les amplificateurs avec des courants électriques différents.

Dans ce cas, on peut ajuster ces courants électriques pour que le point A de la courbe de transmission de l'interféromètre corresponde à une puissance de pompe nulle.

Le premier inconvénient évoqué ci-dessus disparaît mais pas le deuxième puisque les gains, qui sont respectivement obtenus sur les deux bras de l'interféromètre, sont différents même sans saturation.

De plus, l'utilisation de deux courants de polarisation différents, même si elle est possible dans un laboratoire, peut s'avérer difficile sur le terrain en l'absence de moyens de contrôle.

### EXPOSÉ DE L'INVENTION

La présente invention a pour but de remédier aux inconvénients précédents.

Elle vise à améliorer les dispositifs optiques non-linéaires connus, comprenant un interféromètre optique et deux amplificateurs optiques à semiconducteurs afin
(i) d'augmenter le taux d'extinction de sortie en gardant l'interféromètre équilibré en puissance dans l'état éteint, c'est-à-dire lorsqu'il n'y a pas de signal de pompe, et
(ii) d'obtenir une courbe de transmission de l'interféromètre où, pour un même courant dans les deux amplificateurs, le point A correspond à une puissance de pompe nulle.

Du point (ii), il découle que le taux d'extinction de sortie n'est plus dégradé si le taux d'extinction d'entrée est meilleur qu'un certain seuil puisque le seuil critique désigné par PpA dans la figure 3A est nul.

Grâce au point (i), le taux d'extinction de sortie est nettement amélioré par rapport au cas classique.

De plus, ces améliorations permettent un fonctionnement du dispositif avec un même courant de polarisation des amplificateurs, ce qui rend ce dispositif plus pratique.

De façon précise, la présente invention a pour objet un dispositif optique non-linéaire de traitement d'un signal optique, ce dispositif étant caractérisé en ce qu'il comprend :
- un interféromètre optique comportant deux bras qui sont destinés à recevoir le signal optique à traiter, et
- deux amplificateurs optiques à semiconducteurs qui sont respectivement insérés dans les deux bras de l'interféromètre, de manière à pouvoir modifier l'indice de réfraction de l'un de ces amplificateurs par injection d'un autre signal optique, appelé signal de pompe, dans le bras correspondant de l'interféromètre,
et en ce que les caractéristiques opto-géométriques (notamment la longueur et/ou la largeur et/ou l'indice optique) ou structurelles d'au moins l'un des deux bras de l'interféromètre sont adaptées à l'introduction d'un déphasage égal à π entre les deux bras de l'interféromètre, c'est-à-dire entre deux ondes optiques se propageant respectivement dans ces deux bras.

L'interféromètre peut être un interféromètre de Michelson ou un interféromètre de Mach-Zehnder symétrique ou encore un interféromètre de Mach-Zehnder asymétrique.

De préférence, le dispositif objet de l'invention comprend en outre des moyens de polarisation des deux amplificateurs optiques par le même courant électrique.

Selon un premier mode de réalisation particulier du dispositif objet de l'invention, les deux bras de l'interféromètre présentent une différence de longueur apte à introduire le déphasage égal à π entre ces bras.

Selon un deuxième mode de réalisation particulier, les deux bras de l'interféromètre ont la même longueur et présentent une différence de largeur apte à introduire le déphasage égal à π entre ces bras.

Selon un troisième mode de réalisation particulier, utilisable en combinaison avec le premier ou le deuxième mode de réalisation, les moyens d'introduction du déphasage comprennent des moyens de modification de l'indice de réfraction de l'un des bras de l'interféromètre.

Dans ce cas, l'un des bras de l'interféromètre peut être enrobé d'un matériau diélectrique apte à modifier l'indice de réfraction de ce bras de manière à obtenir le déphasage égal à π entre les bras.

En variante, les moyens de modification d'indice de réfraction peuvent comprendre :
- un modulateur électro-optique inséré dans l'un des bras de l'interféromètre,
- ou des moyens de chauffage localisé de l'un des bras de l'interféromètre,
- ou encore des moyens de couplage optique évanescent variable de l'un des bras de l'interféromètre avec un guide d'onde optique.

Selon un quatrième mode de réalisation particulier du dispositif objet de l'invention, ce dispositif comprend en outre au moins un coupleur optique multimode par interférence ("*optical multimode interference coupler"*) de type 1x1, ce coupleur étant inséré dans l'un des bras de l'interféromètre et apte à introduire le déphasage égal à π.

Le dispositif peut comprendre deux tels coupleurs respectivement insérés dans les bras de l'interféromètre et choisis de manière à créer des retards de phase respectifs dont la différence est égale à π.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- la figure 1 est une vue schématique d'un dispositif optique non-linéaire de traitement de signal connu et a déjà été décrite,
- la figure 2 représente la courbe de transmission de l'interféromètre que comprend le dispositif de la figure 1 et a déjà été décrite,
- les figures 3A, 3B et 3C illustrent respectivement trois modes de fonctionnement du dispositif de la figure 1, suivant la valeur du taux d'extinction d'entrée relatif à ce dispositif, et ont déjà été décrites,
- la figure 4 représente les variations du taux d'extinction maximal de sortie du dispositif, en fonction du déséquilibrage de l'interféromètre de ce dispositif, et a déjà été décrite,
- la figure 5 est une vue schématique d'un dispositif conforme à l'invention,
- les figures 6 et 7 illustrent schématiquement des modes de réalisation particuliers du dispositif objet de l'invention, correspondant à des modifications des paramètres géométriques du dispositif de la figure 1 afin d'obtenir un déphasage conformément à la présente invention,
- les figures 8 à 11 illustrent schématiquement d'autres modes de réalisation particuliers du dispositif objet de l'invention, utilisant divers moyens de modification de l'indice de réfraction d'un bras de l'interféromètre que comprend le dispositif de la figure 1 en vue d'introduire ce déphasage,
- les figures 12 et 13 sont des vues schématiques d'autres modes de réalisation particuliers du dispositif objet de l'invention, utilisant un ou deux coupleurs optiques multi-modes par interférence de type 1x1, et
- la figure 14 est une vue schématique d'un autre mode de réalisation particulier du dispositif objet de l'invention, utilisant un interféromètre de Michelson.

### EXPOSÉ DÉTAILLÉ DE MODES DE RÉALISATION PARTICULIERS

Dans le dispositif connu schématiquement représenté sur la figure 1, l'interféromètre est naturellement "ouvert" : sa transmission est maximale lorsque le dispositif est au repos c'est-à-dire lorsqu'il n'y a pas de signal de pompe.

En effet, les chemins optiques correspondant respectivement aux deux bras de cet interféromètre sont identiques.

Dans la présente invention, on utilise au contraire un interféromètre qui est naturellement "fermé" c'est-à-dire dont la transmission est nulle lorsqu'il n'y a pas de signal de pompe.

Alors, étant donné un signal d'entrée dont l'intensité est constante, on obtient un signal d'intensité nulle à la sortie de l'interféromètre (alors que cette intensité serait maximale dans le cas du dispositif connu de la figure 1).

Pour obtenir cet interféromètre naturellement fermé, on introduit un déphasage égal à π entre les deux bras de l'interféromètre d'un dispositif optique non-linéaire connu, par exemple du genre de celui de la figure 1.

Le dispositif conforme à l'invention, qui est schématiquement représenté sur la figure 5, diffère simplement de celui qui est représenté sur la figure 1 par le fait qu'il comprend, en plus, des moyens 30 d'introduction d'un déphasage égal à π entre les bras 8 et 10 de l'interféromètre I, c'est-à-dire des moyens 30 d'introduction d'un déphasage égal à π entre deux ondes optiques se propageant respectivement dans ces deux bras 8 et 10.

Il est à noter que ces moyens d'introduction du déphasage peuvent être placés entre la jonction optique 4 et les amplificateurs 12 et 14 ou entre ces amplificateurs 12 et 14 et la jonction optique 6.

De plus, ces moyens 30 d'introduction de déphasage peuvent concerner l'un ou l'autre des deux bras 8 et 10 de l'interféromètre I ou les deux bras de ce dernier.

Grâce à ces moyens 30, pour un même courant de polarisation i envoyé à chacun des amplificateurs 12 et 14 par les moyens 16, le déphasage total entre les deux bras 8 et 10 est naturellement égal à π et correspond à des interférences destructives.

Comme les amplificateurs sont polarisés par le même courant i, l'interféromètre de Mach-Zehnder I reste équilibré et le taux d'extinction de sortie est donc optimal.

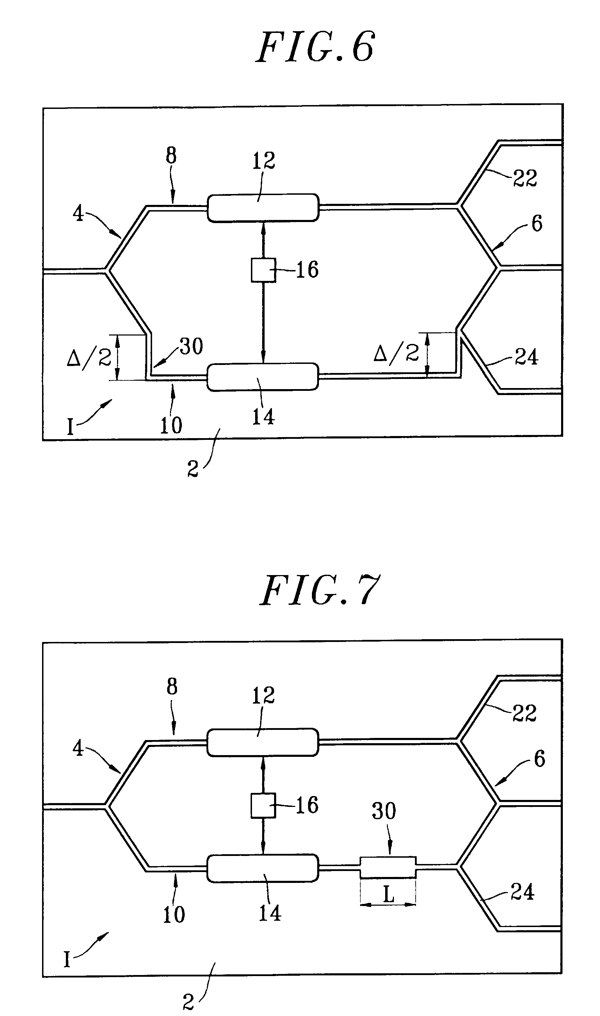

Les figures 6 à 14 illustrent schématiquement divers modes de réalisation particuliers du dispositif objet de l'invention, correspondant à diverses manières d'obtenir le déphasage égal à π entre les deux bras 8 et 10 de l'interféromètre I de type Mach-Zehnder symétrique.

Les jonctions optiques 22 et 24, dont l'une permet d'amener le signal de pompe, sont telles que l'interféromètre reste équilibré en puissance.

Une première manière d'obtenir le déphasage égal à π consiste à modifier les paramètres géométriques de l'interféromètre I du dispositif connu de la figure 1.

On peut par exemple légèrement diminuer ou augmenter le chemin optique en modifiant la longueur de propagation de la lumière dans le guide d'onde du bras considéré de l'interféromètre, pour donner à cette longueur la valeur appropriée permettant d'obtenir le déphasage de π.

Il faut que la différence Δ entre les longueurs des deux bras 8 et 10 soit un multiple impair de la quantité λ/(2n) où λ représente la longueur d'onde de la lumière guidée et n représente l'indice effectif du mode guidé.

Cette différence est environ égale à 0,5 µm si λ est de l'ordre de 1,5 µm et n de l'ordre de 3,5.

Ceci est schématiquement illustré par la figure 6 où le bras 10 a une longueur supérieure à celle du bras 8.

Une autre manière de procéder consiste à modifier, de préférence localement, la largeur de ce guide d'onde.

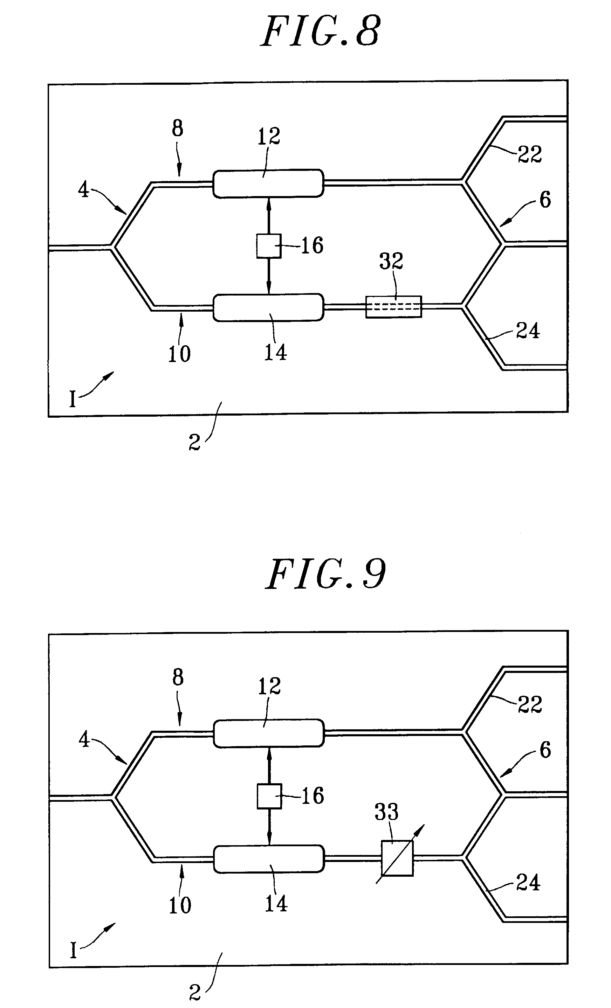

Ceci est schématiquement illustré par la figure 7 dans laquelle les guides d'ondes formant les bras 8 et 10 ont la même longueur et la même largeur sauf pour le guide d'onde correspondant au bras 10 de l'interféromètre dont la largeur est localement augmentée.

Une faible variation de largeur du guide d'onde (suffisante pour qu'il reste monomode) correspond à une variation Δn d'indice optique.

Connaissant la valeur de Δn, on est capable de calculer la longueur L de la portion élargie du bras 10.

Par exemple, si Δn est égal à 0,002 alors L est égal à 382 µm.

Cette variation d'indice optique doit être identique pour le mode transverse électrique TE et le mode transverse magnétique TM.

Une autre manière de procéder pour obtenir le déphasage de π consiste à munir le dispositif connu de la figure 1 de moyens de modification de l'indice de réfraction de l'un des bras par rapport à l'autre bras.

Comme l'illustre schématiquement la figure 8, on peut modifier l'indice de réfraction de l'un des deux bras de l'interféromètre (qui ont la même longueur), par exemple le bras 10, en enrobant le guide d'onde correspondant d'un matériau diélectrique 32 dont la quantité est éventuellement ajustable, par ablation laser par exemple.

En tant que moyens de modification de l'indice de réfraction on peut aussi utiliser un modulateur de phase 33, comme l'illustre schématiquement la figure 9.

Dans ce cas, ce modulateur est intégré de façon monolithique au substrat semiconducteur 2 du dispositif de la figure 1, sur l'un des deux bras de l'interféromètre (qui ont la même longueur), le bras 10 dans l'exemple représenté sur la figure 9.

Ce modulateur est fondé sur le changement d'indice de réfraction par injection de courant ou par application d'un champ électrique.

Les moyens de commande de ce modulateur 33 ne sont pas représentés sur la figure 9.

En variante, on peut utiliser, en tant que moyens de modification de l'indice de réfraction, des moyens de chauffage localisé du guide d'onde correspondant à l'un des deux bras de l'interféromètre (qui ont la même longueur), par exemple le bras 10.

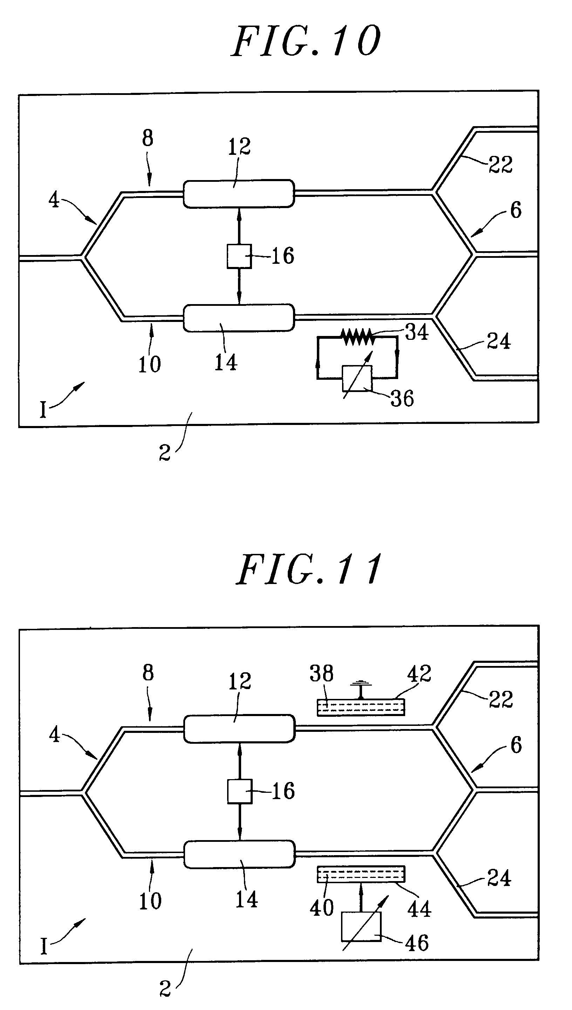

Comme l'illustre schématiquement la figure 10, ces moyens de chauffage peuvent comprendre une résistance électrique 34, par exemple en platine, et des moyens 36 permettant d'appliquer une tension électrique variable entre les bornes de cette résistance électrique.

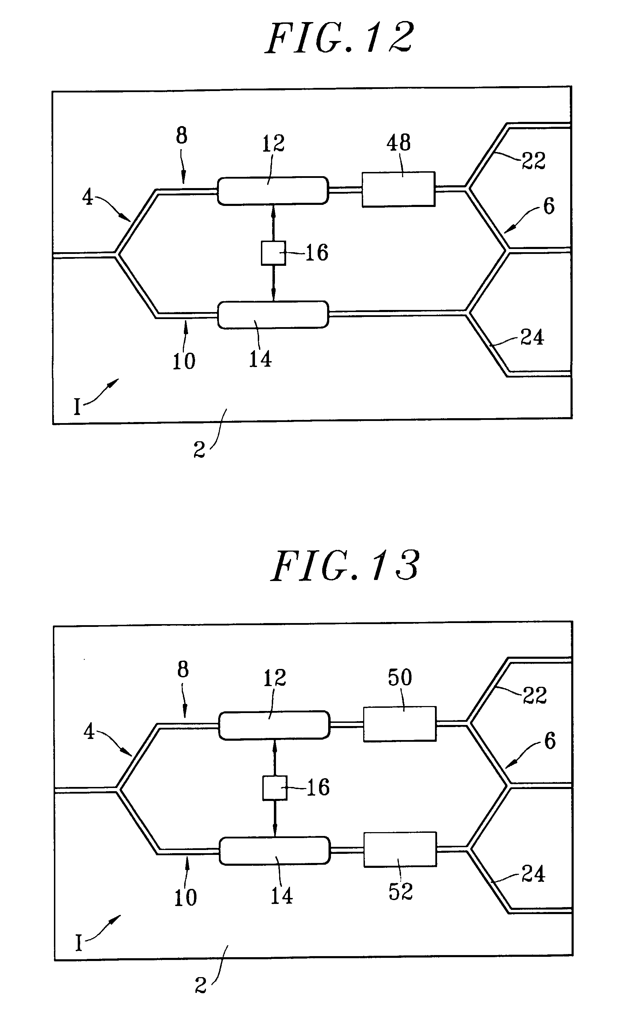

On peut également utiliser, en tant que moyens de variation de l'indice de réfraction, des moyens de couplage optique évanescent variable, comme l'illustre schématiquement la figure 11.

Dans l'exemple schématiquement représenté sur cette figure 11, ces moyens de couplage comprennent deux guides d'onde supplémentaires 38 et 40 de même longueur, qui sont intégrés au substrat 2 et respectivement placés à faible distance des deux bras 8 et 10 (de même longueur) de l'interféromètre I, parallèlement à ces bras.

Ces guides d'onde 38 et 40 sont respectivement recouverts par des électrodes 42 et 44.

L'une de ces électrodes, l'électrode 42 dans l'exemple représenté, est mise à la masse tandis que l'autre électrode 44 est reliée à des moyens 46 permettant de porter cette électrode 44 à un potentiel électrique variable.

On est ainsi capable d'appliquer un champ électrique variable au guide d'onde 40 et l'on est donc capable de faire varier l'indice de réfraction de celui-ci, d'où le couplage optique évanescent variable entre l'interféromètre et les guides d'onde 38 et 40.

En variante, on fait varier l'indice de réfraction du guide d'onde supplémentaire 40 par des moyens permettant d'injecter un courant électrique variable dans ce guide d'onde 40.

Bien évidemment, on peut combiner, les unes avec les autres, les diverses solutions considérées pour modifier l'indice de réfraction.

On peut ainsi combiner l'un quelconque des modes de réalisation des figures 6 à 8 avec l'un quelconque des modes de réalisation des figures 9 à 11 de manière à pouvoir obtenir un réglage fin de la valeur de l'indice de réfraction.

Un autre mode de réalisation particulier du dispositif objet de l'invention est schématiquement représenté sur la figure 12.

Dans le cas de la figure 12, on utilise un coupleur optique multi-mode par interférence 48 ("*optical multi-mode interference coupler*") de type 1x1.

Au sujet d'un tel coupleur, on se reportera au document (5).

Ce coupleur multi-mode par interférence 48 est formé dans le substrat 2 et intégré au guide d'onde correspondant au bras 8 de l'interféromètre I.

De plus, il est choisi pour créer un retard de phase égal à π.

Le guide d'onde de l'autre bras 10 n'est pas modifié.

Dans un autre mode de réalisation particulier, qui est schématiquement illustré par la figure 13, on utilise deux coupleurs multi-modes par interférence 50 et 52 de type 1x1 qui sont formés dans le substrat 2 et respectivement intégrés aux guides d'ondes formant les bras 8 et 10 de l'interféromètre I.

Les coupleurs 50 et 52 sont choisis de manière à créer des retards de phase respectifs dont la différence est égale à π.

Dans les modes de réalisation particuliers de l'invention, qui sont schématiquement illustrés par les figures 5 à 13, on pourrait utiliser un interféromètre de Mach-Zehnder de type asymétrique au lieu d'un interféromètre de Mach-Zehnder de type symétrique.

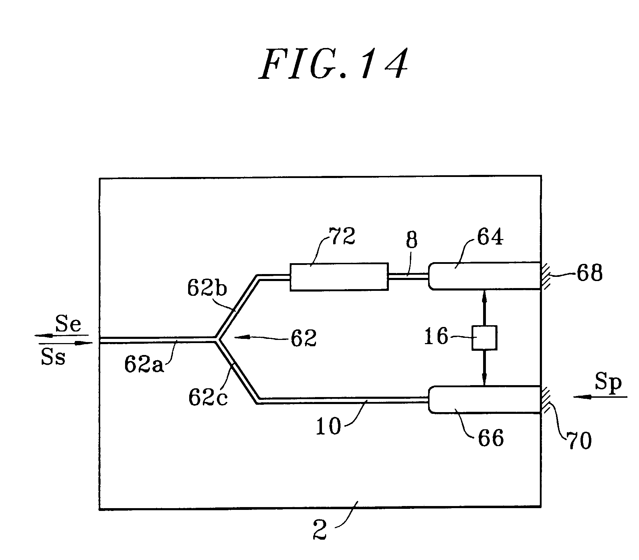

Un autre mode de réalisation particulier du dispositif objet de l'invention est schématiquement représenté sur la figure 14 et utilise un interféromètre de Michelson.

Cet interféromètre de Michelson est intégré sur un substrat semiconducteur 2.

Il comprend une jonction optique en Y référencée 62 et formée dans le substrat 2.

Les trois branches de ce coupleur 62 ont respectivement les références 62a, 62b et 62c.

Cet interféromètre comprend aussi les deux guides d'ondes 8 et 10 qui sont respectivement couplés aux branches 62b et 62c du coupleur 62.

Le dispositif de la figure 14 comprend aussi deux amplificateurs optiques à semiconducteurs 64 et 66 qui sont intégrés dans le substrat 2, aux extrémités respectives des deux guides 8 et 10.

Ces deux amplificateurs, commandés par les moyens 16 mentionnés plus haut, sont terminés par des miroirs semi-transparents 68 et 70.

Dans l'un des guides 8 et 10 (qui forment les bras de l'interféromètre de Michelson) est inséré un moyen 72 permettant d'obtenir un déphasage de π/2 entre deux ondes optiques se propageant dans les deux bras de l'interféromètre de Michelson.

Étant donné que, dans un tel interféromètre, ces ondes optiques repassent dans ces bras, on obtient bien le déphasage souhaité, égal à π, entre les deux bras de l'interféromètre.

Dans le dispositif de la figure 14, le signal d'entrée Se, que l'on veut moduler, est injecté dans la branche 62a du coupleur 62 et l'on récupère également le signal de sortie Ss à l'extrémité de cette branche 62a.

Le signal de pompe Sp est, quant à lui, injecté dans le bras 10 de l'interféromètre, à travers le miroir semi-transparent 70 correspondant à ce bras 10.

Les documents cités dans la présente description sont les suivants :
(1) J.M. Wiesenfeld, B. Glance, J.S. Perino, A.H. Gnauck, "Wavelength conversion at 10 Gb/s using a semiconductor amplifier", IEEE Photonics Technol. Lett., vol 5, n°11, pp. 1300 à 1303, 1993
(2) B. Mikkelsen, T. Durhuus, C. Joergensen, R.J.S. Pedersen, C. Braagaard, K.E. Stubkjaer, "Polarisation insensitive wavelength conversion of 10 Gb/s signals with SOAs in a Michelson interferometer", Electron. Lett., vol.30, n°3, pp. 260 et 261, 1994
(3) F. Ratovelomanana, N. Vodjani, E. Enard, G. Glastre, D. Rondi, R. Blondeau, C. Joergensen, T. Durhuus, B. Mikkelsen, K.E. Stubkjaer, A. Jourdan, G. Soulage, "An all-optical wavelength converter with semiconductor optical amplifier monolithically integrated in an asymetric passive Mach-Zehnder interferometer", IEEE Photonics Technol. Lett., vol.7, n°10, pp. 992 à 994, 1995
(4) W. Idler, M. Schilling, K. Daub, E. Lach, G. Laube, U. Koerner, D. Baums, K. Wünstel, "Compact monolithic wavelength converter with srong signal improvement including chirp compression", Compte-rendus de la 21ème *Conference on Optical Communications (ECOC'95),* Brussels, p.621 à 624
(5) L.B. Soldano, E.C.M. Pennings, "Optical Multi-Mode Interference Devices Based on self-imaging : principles and applications", *J*. *Lightwave Technol.,* vol.13 (4), pp.615 à 627, 1995.

## Revendications

1. Dispositif optique non-linéaire de traitement d'un signal optique, ce dispositif étant caractérisé en ce qu'il comprend :
• un interféromètre optique comportant deux bras (8, 10) qui sont destinés à recevoir le signal optique à traiter, et
• deux amplificateurs optiques à semiconducteurs (12, 14; 64, 66) qui sont respectivement insérés dans les deux bras de l'interféromètre, de manière à pouvoir modifier l'indice de réfraction de l'un de ces amplificateurs par injection d'un autre signal optique, appelé signal de pompe, dans le bras correspondant de l'interféromètre,
et en ce que les caractéristiques opto-géométriques ou structurelles d'au moins l'un des deux bras de l'interféromètre sont adaptées à l'introduction d'un déphasage égal à π entre les deux bras de l'interféromètre.

2. Dispositif selon la revendication 1, caractérisé en ce que l'interféromètre est un interféromètre de Michelson.

3. Dispositif selon la revendication 1, caractérisé en ce que l'interféromètre est un interféromètre de Mach-Zehnder symétrique.

4. Dispositif selon la revendication 1, caractérisé en ce que l'interféromètre est un interféromètre de Mach-Zehnder asymétrique.

5. Dispositif selon l'une quelconque des revendications 1 à 4, caractérisé en ce qu'il comprend en outre des moyens (16) de polarisation des deux amplificateurs optiques par le même courant électrique.

6. Dispositif selon l'une quelconque des revendications 1 à 5, caractérisé en ce que les deux bras (8, 10) de l'interféromètre présentent une différence de longueur apte à introduire le déphasage égal à π entre ces bras.

7. Dispositif selon l'une quelconque des revendications 1 à 5, caractérisé en ce que les deux bras (8, 10) de l'interféromètre ont la même longueur et présentent une différence de largeur apte à introduire le déphasage égal à π entre ces bras.

8. Dispositif selon l'une quelconque des revendications 1 à 7, caractérisé en ce que les moyens d'introduction du déphasage comprennent des moyens (32; 33; 34, 36; 42, 44, 46) de modification de l'indice de réfraction de l'un des bras de l'interféromètre.

9. Dispositif selon la revendication 8, caractérisé en ce que l'un des bras de l'interféromètre est enrobé d'un matériau diélectrique (32) apte à modifier l'indice de réfraction de ce bras de manière à obtenir le déphasage égal à π entre les bras.

10. Dispositif selon la revendication 8, caractérisé en ce que les moyens de modification d'indice de réfraction comprennent un modulateur électro-optique (33) qui est inséré dans l'un des bras de l'interféromètre.

11. Dispositif selon la revendication 8, caractérisé en ce que les moyens de modification d'indice de réfraction comprennent des moyens (34, 36) de chauffage localisé de l'un des bras de l'interféromètre.

12. Dispositif selon la revendication 8, caractérisé en ce que les moyens de modification d'indice de réfraction comprennent des moyens (42, 44, 46) de couplage optique évanescent variable de l'un des bras de l'interféromètre avec un guide d'onde optique (40).

13. Dispositif selon l'une quelconque des revendications 1 à 5, caractérisé en ce qu'il comprend en outre au moins un coupleur optique multimode par interférence (48; 50, 52) de type 1x1, ce coupleur étant inséré dans l'un des bras de l'interféromètre et apte à introduire le déphasage égal à π.

14. Dispositif selon la revendication 13, caractérisé en ce qu'il comprend deux tels coupleurs (50, 52), qui sont respectivement insérés dans les bras de l'interféromètre et choisis de manière à créer des retards de phase respectifs dont la différence est égale à π.
